# EUROPEAN PATENT APPLICATION

(11) **EP 0 707 338 A2**
(43) Date of publication of application: **17.04.1996**
(21) Application number: 94830577.6
(22) Date of filing: 15.12.1994
(51) Int. Cl.: H01L 21/20

(54) **Wafer of semiconductor material for fabricating integrated semiconductor devices, and process for its fabrication**

(30) Priority: 13.10.1994 IT TO940818
(71) Applicant: SGS-THOMSON MICROELECTRONICS S.r.l., I-20041 Agrate Brianza (Milano) (IT)
(72) Inventor: Murari, Bruno, I-20052 Monza (IT); Villa, Flavio, I-20159 Milano (IT); Mastromatteo, Ubaldo, I-20010 Cornaredo (IT)
(74) Representative: Cerbaro, Elena

(57) **Abstract**

A wafer (20) of semiconductor material for fabricating integrated devices, comprising a stack of superimposed layers including a first (21) and second (24) monocrystalline silicon layer separated by an intermediate polycrystalline diamond layer (22). An oxide bond layer (23) is provided between the intermediate layer (22) and the second silicon layer (24); and the wafer is fabricated by growing the intermediate diamond layer (22) on the first silicon layer (21) in a heated vacuum chamber supplied with a hydrocarbon mixture; depositing the oxide layer; and superimposing the second silicon layer. When the stack of silicon, diamond, oxide and silicon layers is heat treated, the oxide reacts so as to bond the diamond layer to the second silicon layer. Alternatively, instead of diamond, the intermediate layer (22) is formed from silicon carbide or ceramic materials such as beryllium oxide, aluminium nitride, and alumina.

## Description

The present invention relates to a wafer of semiconductor material for fabricating integrated devices, and to a process for its fabrication.

As is known, in the microelectronics industry, the substrate of integrated devices is commonly formed from monocrystalline silicon wafers. In recent years, however, by way of an alternative to all-silicon wafers, so-called SOI (Silicon-on-Insulator) wafers have been proposed, which consist of two layers of silicon, one thinner than the other, separated by a layer of silicon oxide (see, for example, the article entitled: "Silicon-on-Insulator Wafer Bonding-Wafer Thinning Technological Evaluations" by J. Hausman, G.A. Spierings, U.K.P. Bierman and J.A. Pals, Japanese Journal of Applied Physics, Vol. 28, N. 8, August 1989, p. 1426-1443).

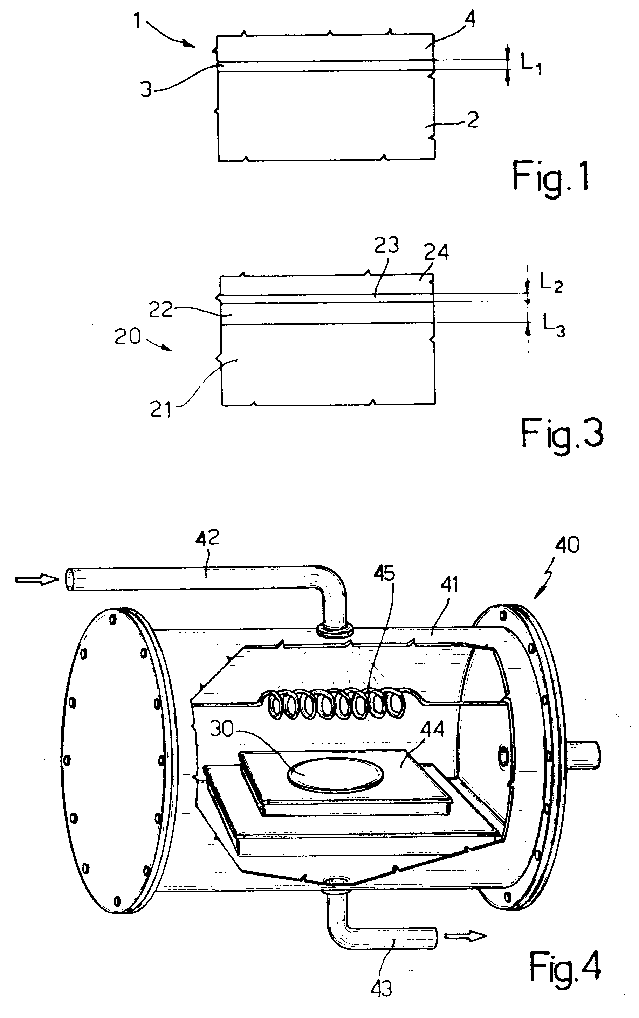

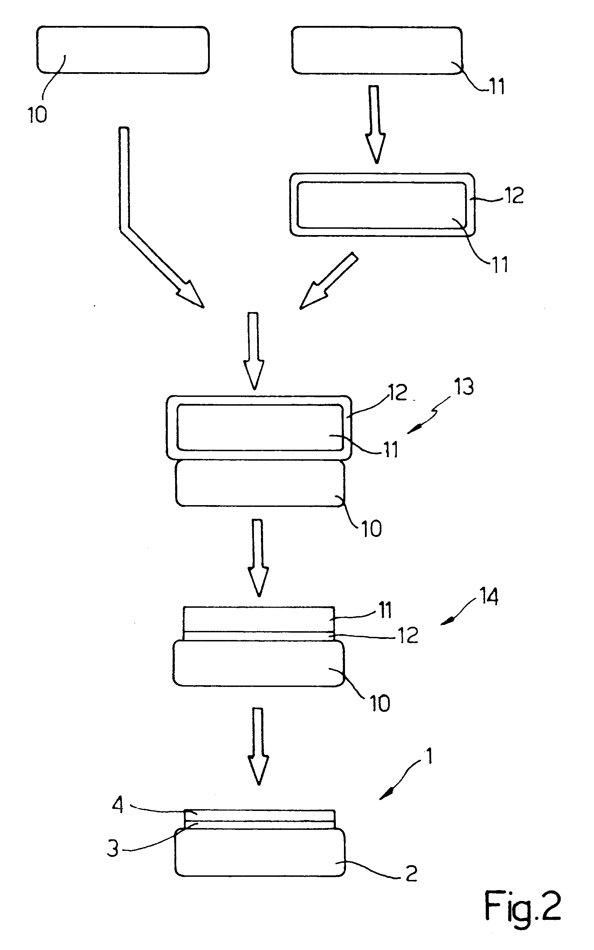

Figure 1 shows a cross section of a portion of a SOI wafer 1 presenting a first (thicker) layer of monocrystalline silicon 2, an intermediate silicon oxide layer 3, and a second (thinner) layer of monocrystalline silicon 4 on which an epitaxial layer (not shown) may subsequently be grown. The intermediate oxide layer 3 presents a thickness L₁ of preferably 0.2 to 10 µm.

SOI wafers have recently attracted a good deal of attention on account of the major advantages of integrated circuits with substrates formed from such wafers, as compared with the same circuits with conventional monocrystalline silicon substrates; which advantages may be summed up as follows:
a) higher switching speed;
b) better immunity to noise;
c) low loss currents;
d) no latch-up;
e) reduced stray capacitance;
f) better resistance to radiation;
g) higher component packing density.

A typical SOI wafer fabrication process will now be described with reference to the Figure 2 diagram.

The process commences with two normally fabricated monocrystalline silicon wafers 10 and 11. Wafer 10 is the one eventually constituting the bottom base layer, and is accurately sized; while wafer 11 is the one which will eventually be thinned and bonded (via the interposition of an oxide layer) to wafer 10. Wafer 11 (also known as the "bond wafer") is oxidized thermally to form an oxide layer 12 covering it entirely; and, after being cleaned, wafers 10 and 11 are superimposed and heat treated at 1100°C for roughly 2 hours to "bond" them together.

During bonding, the following chemical reaction takes place:

≡SiOH + HOSi≡ => ≡Si-O-Si≡ + H₂O (1)

wherein the SiOH groups are present in oxide layer 12; at the heat treatment temperature shown, OH⁻ ions are free and become highly mobile in oxide layer 12, to form a strong chemical bond between oxide layer 12 (and hence wafer 11) and wafer 10, and so form a semifinished wafer 13.

Semifinished wafer 13 is then surface ground to form a body 14, and finally lapped and polished to form wafer 1.

Despite the major advantages listed above, SOI wafers are of limited application on account of the poor thermal conductivity of the silicon oxide layer. Silicon, in fact, is known to present a thermal conductivity of 150 W/(m°C) as compared with 1.4 W/(m°C) for silicon oxide (two orders of magnitude lower). As the total thermal resistance of the wafer equals the sum of the thermal resistances of the individual layers (in series with one another), wafer 1, for a given total thickness, presents a much greater thermal resistance as compared with a traditional monocrystalline silicon wafer. In other words, to achieve the same thermal resistance, silicon layer 2 would have to be thinned by a factor depending on the ratio between the conductivity of silicon oxide and monocrystalline silicon (as shown above, equal to roughly 100) and bearing in mind the thickness of the oxide layer. Such thinning, however, would impair the mechanical strength of the wafer, and is therefore unfeasible, at least for the great majority of applications.

In view of the continual reduction in component size and the need for operating at an increasingly high operating current density, SOI substrates therefore fail to provide for sufficient heat dissipation, thus resulting in excessively high junction temperatures, and impaired reliability of the components. In the case of power components, in particular, a limitation in current flow occurs. Such negative effects are especially damaging in the case of high-voltage integrated circuits requiring thicker intermediate oxide layers.

It is an object of the present invention to provide a wafer which exploits the inherent advantages of SOI technology, but which presents none of the above limitations of application.

According to the present invention, there are provided a wafer of semiconductor material for fabricating integrated devices, and a process for its fabrication, as claimed respectively in Claims 1 and 17.

A number of preferred, non-limiting embodiments of the present invention will be described by way of example with reference to the accompanying drawings, in which:
Figure 1 shows a known type of wafer;
Figure 2 shows the process for fabricating the Figure 1 wafer;
Figure 3 shows a cross section of a wafer of semiconductor material in accordance with the present invention;
Figure 4 shows the reactor employed in one embodiment of the fabrication process according to the present invention;
Figure 5 shows a flow chart of one embodiment of the process according to the present invention.

Number 20 in Figure 3 indicates a wafer of semiconductor material, comprising a stack of superimposed layers in turn comprising a first layer 21 of monocrystalline silicon; a layer 22 of electrically insulating material but of high thermal conductivity (over 20 W/m°K); a bond layer 23; and a second layer 24 of monocrystalline silicon.

More specifically, insulating layer 22 may consist of mono- or polycrystalline diamond, silicon carbide (SiC), or ceramic material such as beryllium oxide (BeO), aluminium nitride (AlN) or alumina (Al₂O₃); and the thickness of insulating layer 22 depends on the maximum voltage the wafer is called upon to withstand, bearing in mind the dielectric rigidity of the material (which, in the case of monocrystalline diamond, for example, is roughly 300 V/µm).

Bond layer 23 may consist of silicon oxide or a layer of polycrystalline silicon, and is so selected as to ensure bonding to insulating layer 22. If insulating layer 22 consists of polycrystalline diamond, bond layer 23 preferably consists of TEOS (tetraethylorthosilicate) oxide, but may also consist of oxygen-plasma-activated CVD (Chemical-Vapour-Deposited) oxide, and presents a thickness ranging preferably between 200 Å and 0.2 µm. If insulating layer 22 consists of silicon carbide, bond layer 23 preferably consists of polysilicon or thermal oxide.

In addition to the advantages typical of SOI wafers, wafer 20 also presents a distinct improvement in thermal dissipation. For example, if layer 22 is made of polycrystalline diamond, which presents an extremely high thermal conductivity of >1000-2000 W/(m°K), insertion of layer 22 within wafer 20 provides for improving the overall thermal conductivity. Moreover, the high conductivity of the diamond layer more than compensates for the deficiency induced by bond layer 23 which, being thin, does not present a high thermal resistance anyway.

Adhesion of layer 22 to monocrystalline silicon layer 21 is excellent, and no stress is generated between the two layers by virtue of the coefficient of linear thermal expansion of monocrystalline silicon being the same as that of polycrystalline diamond (roughly 2x10⁻⁶/°C) and nearly the same as that of silicon carbide (3.3x10⁻⁶/°C).

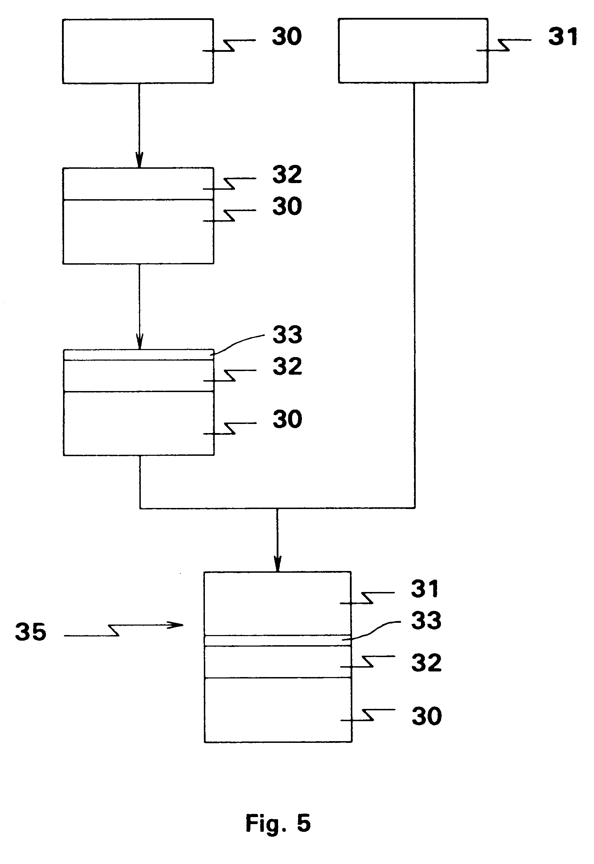

The process for fabricating wafer 20 with a layer 22 consisting of polycrystalline diamond and deposited oxide will be described with reference to Figures 4 and 5. The process commences with two wafers 30, 31 of monocrystalline silicon; wafer 30 being the one eventually constituting the bottom portion of the substrate; and wafer 31 being the one eventually constituting the thinner top portion; and a layer 32 of polycrystalline diamond (Figure 5) is grown on wafer 30 using the HFCVD (Hot Filament Chemical Vapour Deposition) method described, for example, in Patent US-A-5,126,206, and implemented using the reactor shown in Figure 4 and described briefly below.

Reactor 40 in Figure 4 comprises a vacuum chamber 41 (10-100 torr) having an inlet conduit 42 for a mixture of hydrocarbons and H₂, and an exhaust gas outlet conduit 43, and housing a support 44, including a heater (not shown), for monocrystalline silicon wafer 30 and an electrically heated filament 45.

Wafer 30 is preheated to 750-900°C, so that the gas from inlet conduit 42 is activated by filament 45, spreads towards and reacts with wafer 30, and, on condensing, forms a high-quality polycrystalline diamond layer 32 (Figure 5) adhering perfectly to wafer 30.

On layer 32, there is then deposited an oxide layer 33 which, as stated above, may be TEOS or CVD oxide in the presence of plasma, to ensure adhesion to diamond layer 32.

Wafer 31 is then placed on top of oxide layer 33 and the two are bonded using a process similar to the one shown in Figure 2 for bonding oxide layer 12 to wafer 10. As silicon oxide layer 33 contains bonded hydrogen, in the silicon-oxygen matrix, in the form of SiOH, silane (SiH) and water, it is hydrophylic and, when heat treated, permits the reaction (1) indicated with reference to Figure 2, so as to bond monocrystalline silicon layer 31 to diamond layer 32, and form wafer 35 which may then be ground and polished in the usual way to form wafer 20 in Figure 3.

Alternatively, in the case of an insulating layer 22 of silicon carbide, this is preferably deposited by PECVD (Plasma Enhanced Chemical Vapour Deposition) using a process which may also be described with reference to Figure 5. To form the silicon carbide layer, monocrystalline silicon wafer 30 is placed on a substrate in a reaction chamber; the support is preheated to roughly 400°C; by feeding a mixture of silane (SiH₄) and methane (CH₄) into the reaction chamber, and activating the gas mixture by means of a radiofrequency discharge, a silicon carbide layer 32 is deposited on monocrystalline silicon layer 30; and monocrystalline silicon wafer 31 is bonded to the silicon carbide layer either directly or by means of a bond layer 23. If an oxide layer is used for bonding, this is preferably in the form of a very thin layer - less than 500 Å - of thermal silicon oxide. Alternatively, a polycrystalline silicon layer may be deposited on the silicon carbide layer. In this case, a polycrystalline silicon layer of a few micrometers in thickness is first deposited; the bond layer is ground and polished (mirror machined); monocrystalline silicon wafer 31 is bonded to the polycrystalline silicon layer; and the wafer 35 so formed is then treated in the normal way. Wafer 35 presents extremely good thermal characteristics, by virtue of silicon carbide presenting a thermal conductivity of 350 W/m°C, and polycrystalline silicon presenting a thermal conductivity of 50-85% that of monocrystalline silicon (roughly 75-125 W/m°K).

Clearly, changes may be made to the wafer and fabrication process as described and illustrated herein without, however, departing from the scope of the present invention. In particular, as bond layer 23 provides solely for bonding, it may be eliminated in the event the fabrication process allows bonding monocrystalline silicon layer 21 directly to insulating layer 22. Moreover, the bond layer may be formed from any suitable bonding material, provided that its nature or selected thickness has substantially no effect on the thermal conductivity of the wafer.

## Claims

1. A wafer (20) of semiconductor material for fabricating integrated devices, comprising a stack of superimposed layers including a first (21) and second (24) silicon layer separated by an intermediate insulating layer (22); characterized in that said insulating layer (22) presents a thermal conductivity greater than 20 W/m°K.

2. A wafer as claimed in Claim 1, characterized in that said insulating layer (22) is made of diamond.

3. A wafer as claimed in Claim 2, characterized in that said diamond layer (22) is monocrystalline diamond.

4. A wafer as claimed in Claim 2, characterized in that said diamond layer (22) is polycrystalline diamond.

5. A wafer as claimed in Claim 1, characterized in that said insulating layer (22) is made of silicon carbide.

6. A wafer as claimed in Claim 1, characterized in that said insulating layer (22) is made of ceramic material.

7. A wafer as claimed in Claim 6, characterized in that said ceramic material is selected from the group comprising beryllium oxide, aluminium nitride and alumina.

8. A wafer as claimed in any one of the foregoing Claims, characterized in that said first and second silicon layers (21, 24) are made of monocrystalline silicon.

9. A wafer as claimed in any one of the foregoing Claims, characterized in that it comprises a silicon oxide layer (23) interposed between said insulating layer (22) and said second silicon layer (24).

10. A wafer as claimed in Claim 9, characterized in that said silicon oxide layer (23) is TEOS oxide.

11. A wafer as claimed in Claim 9, characterized in that said silicon oxide layer (23) is oxygen-plasma-activated chemical-vapour-deposited oxide.

12. A wafer as claimed in Claim 9, characterized in that said silicon oxide layer (23) is thermally grown oxide.

13. A wafer as claimed in one of the foregoing Claims from 9 to 12, characterized in that said silicon oxide layer (23) has a thickness ranging between 200 Å and 0.2 µm.

14. A wafer as claimed in Claim 8, characterized in that it comprises a polycrystalline silicon layer (23) interposed between said insulating layer (22) and said second silicon layer (24).

15. A substrate for integrated devices, characterized in that it is formed from a wafer (20) of semiconductor material as claimed in one or more of the foregoing Claims.

16. A process for fabricating a wafer of semiconductor material as claimed in any one of the foregoing Claims from 1 to 14, characterized in that it comprises the steps of forming, on a first silicon layer, an intermediate insulating layer presenting a thermal conductivity greater than 20 W/m°K; and bonding a second silicon layer to said insulating layer.

17. A process as claimed in Claim 16, characterized in that said insulating layer is made of diamond.

18. A process as claimed in Claim 16, characterized in that said insulating layer is made of silicon carbide.

19. A process as claimed in Claim 16, characterized in that said insulating layer is made of ceramic material.

20. A process as claimed in one of the foregoing Claims from 16 to 19, characterized in that said first and second silicon layers are made of monocrystalline silicon.

21. A process as claimed in any one of the foregoing Claims from 16 to 20, characterized in that said bonding step comprises the step of forming an oxide bond layer between said insulating layer and said second silicon layer.

22. A process as claimed in Claim 21, characterized in that said step of forming an oxide bond layer comprises the step of forming a silicon oxide layer on said insulating layer; and said bonding step also comprises the steps of placing said second silicon layer on said oxide layer to form a stack of layers; and heat treating said stack of layers to activate the reaction:
≡SiOH + HOSi≡ => ≡Si-O-Si≡ + H₂O.

23. A process as claimed in Claim 22, characterized in that said bonding step comprises the step of depositing a polycrystalline silicon layer on said insulating layer.

24. A process as claimed in Claim 17, characterized in that said step of forming a diamond layer comprises the step of heating said first silicon layer, supplying a gas comprising a mixture of hydrocarbons, and activating said gas thermally.

25. A process as claimed in Claim 18, characterized in that said step of forming a silicon carbide layer comprises the step of heating said first silicon layer, supplying a gas comprising a mixture of hydrocarbons and silane, and activating said gas.

26. A process as claimed in Claim 21 or 22, characterized in that said step of forming a silicon oxide bond layer comprises the step of depositing a TEOS silicon oxide layer.

27. A process as claimed in Claim 21 or 22, characterized in that said step of forming a silicon oxide bond layer comprises the step of depositing an oxygen-plasma-activated CVD silicon oxide layer.

28. A process as claimed in Claim 21 or 22, characterized in that said bonding step comprises the step of forming a thermal oxide layer on said insulating layer.
